# EUROPÄISCHE PATENTSCHRIFT

(11) **EP 1 258 043 B1**
(45) Veröffentlichungstag und Bekanntmachung des Hinweises auf die Patenterteilung: **18.07.2018**
(21) Anmeldenummer: 00962177.2
(22) Anmeldetag: 31.07.2000
(51) Int. Cl.: H01L 31/18, H01L 31/032, H01L 31/0749, B32B 38/00

(54) **VORRICHTUNG UND VERFAHREN ZUM TEMPERIEREN EINES MEHRSCHICHTKÖRPERS**
METHOD AND DEVICE FOR ANNEALING A MULTI-LAYER BODY
DISPOSITIF ET PROCEDE POUR L'EQUILIBRAGE DE TEMPERATURE D'UN CORPS MULTICOUCHE

(30) Priorität: 30.07.1999 DE 19936081
(43) Veröffentlichungstag der Anmeldung: 20.11.2002
(73) Patentinhaber: Saint-Gobain Glass France S.A., 92400 Courbevoie (FR)
(72) Erfinder: PROBST, Volker, 81547 München (DE)
(74) Vertreter: Gebauer, Dieter Edmund
(86) Internationale Anmeldenummer: PCT/DE2000/002523
(87) Internationale Veröffentlichungsnummer: WO 2001/009961

(56) Entgegenhaltungen:
- EP-A- 0 399 662
- US-A- 5 578 503
- US-A- 5 861 609
- US-A- 5 926 742
- KARG F ET AL: "Novel rapid-thermal-processing for CIS thin-film solar cells" , PROCEEDINGS OF THE PHOTOVOLTAIC SPECIALISTS CONFERENCE. LOUISVILLE, MAY 10 - 14, 1993, NEW YORK, IEEE, US, VOL. CONF. 23, PAGE(S) 441-446 XP010113365 ISBN: 0-7803-1220-1 Seite 441 -Seite 442; Abbildung 1
- ERMER J ET AL: "ADVANCES IN LARGE AREA CUINSE2 THIN FILM MODULES" RECORD OF THE PHOTOVOLTAIC SPECIALISTS CONFERENCE. KISSIMIMEE, MAY 21 - 25, 1990, NEW YORK, IEEE, US, Bd. 1 CONF. 21, 21. Mai 1990 (1990-05-21), Seiten 595-599, XP000480332
- NIEMI E ET AL: "Small- and large-area CIGS modules by co-evaporation" RECORD OF THE 25TH IEEE PHOTOVOLTAIC SPECIALISTS CONFERENCE, 13. - 17. Mai 1996, Seiten 801-804, XP010208271 WASHINGTON, USA
- N. AMIN ET AL.: "New approaches on thinner CdTe thin-film solar cells" 2ND WORLD CONFERENCE ON PHOTOVOLTAIC SOLAR ENERGY CONVERSION, Bd. I, 6. - 10. Juli 1998, Seiten 1081-1084, XP002187109 VIENNA, AT

## Beschreibung

Die Erfindung betrifft eine Vorrichtung zum Temperieren eines Mehrschichtkörpers, der eine erste und mindestens eine zweite Schicht aufweist, durch Aufnahme einer Energiemenge durch den Mehrschichtkörper mit einer Aufnahme einer ersten Teilmenge der Energiemenge durch die erste Schicht und einer Aufnahme einer zweiten Teilmenge der Energiemenge durch die zweite Schicht, aufweisend mindestens eine Energiequelle. Eine derartige Vorrichtung ist beispielsweise aus EP 0 662 247 B1 bekannt. Neben der Vorrichtung werden ein Verfahren zum Temperieren eines Mehrschichtkörpers und ein derartiger Mehrschichtkörper vorgestellt. US 5861609 A1 und EP 0399662 A2 zeigen eine Vorrichtung, bei der ein beschichtetes Substrat zwischen zwei Graphit-Platten in ein Quarzglas-Rohr zur Wärmebehandlung eingebracht wird. Ein Mehrschichtkörper wird beispielsweise dadurch hergestellt, daß auf eine Trägerschicht (Substrat) eine funktionelle Schicht aufgebracht wird. Damit die funktionelle Schicht und/oder die Trägerschicht eine gewünschte physikalische (elektrisch, mechanisch, etc.) und/oder chemische Eigenschaft aufweist, muß unter Umständen eine Prozessierung des Mehrschichtkörpers bzw. der Schicht und/oder der Trägerschicht durchgeführt werden. Die Prozessierung beinhaltet beispielsweise ein Temperieren des Mehrschichtkörpers in Gegenwart eines Gases (Prozeßgas).

Ein Mehrschichtkörper ist beispielsweise eine flächige Dünnfilmsolarzelle, bei der eine Elektrodenschicht aus Molybdän und eine funktionelle Kupfer-Indium-Diselenid(CIS) - Halbleiterschicht auf einer Trägerschicht aus Glas aufgebracht sind. Diese Dünnfilmsolarzelle wird gemäß EP 0 662 247 B1 in einem Zweistufenprozeß hergestellt. In einer ersten Stufe werden der Reihe nach folgende Elemente in Schichtform auf die Trägerschicht aus Glas aufgebracht: Molybdän, Kupfer, Indium und Selen. Der so erhaltene Mehrschichtkörper wird in einer zweiten Stufe temperiert, wobei sich die Kupfer-Indium-Diselenid - Halbleiterschicht ausbildet.

Zum Temperieren wird der Mehrschichtkörper in einem geschlossenen Behälter aus Graphit angeordnet. Während des Temperierens bildet sich im Behälterinneren ein bestimmter Partialdruck gasförmigen Selens aus, wobei die auf dem Glas aufgebrachten Schichten mit dem gasförmigen Selen in Kontakt stehen.

Beim Temperieren nimmt der Mehrschichtkörper eine Energiemenge auf, wobei jeder Schicht eine Teilmenge der Energiemenge zugeführt wird. Das Temperieren erfolge beispielsweise mit einer Aufheizrate von 10°C/s. Als Energiequelle der Energiemenge wird eine Halogenlampe benutzt. Mit der Halogenlampe wird der Behälter aus Graphit bestrahlt und somit der Behälter aufgeheizt. Ein derartiger Vorgang ist besonders effizient, da Graphit als quasi "Schwarzer Strahler" ein hohes Absorptionsvermögen für elektromagnetische Strahlung aufweist, insbesondere für Strahlung im Spektralbereich der Halogenlampe. Die durch das Graphit absorbierte Energiemenge wird durch Wärmestrahlung und/oder Wärmeleitung dem Mehrschichtkörper zugeführt. Der Behälter fungiert somit als sekundäre Energiequelle bzw. als Energietransmitter.

Graphit weist ein hohes Emissionsvermögen und eine hohe Wärmeleitfähigkeit auf. Bei Aufliegen des Mehrschichtkörpers auf einem Boden des Behälters erfolgt die Zufuhr der Energiemenge auf einer Unterseite des Mehrschichtkörpers im wesentlichen durch Wärmeleitung. Einer Oberseite des Mehrschichtkörpers her wird eine Energiemenge durch Wärmestrahlung zugeführt.

Aufgrund eines unsymmetrischen Schichtaufbaus des Mehrschichtkörpers und/oder einer unterschiedlichen Zuführung der Energiemenge auf die Ober- und Unterseite des Mehrschichtkörpers kann es bei einer hohen Aufheizrate zu einem inhomogenen, d.h. ungleichmäßigen Temperieren der Schichten des Mehrschichtkörpers kommen. Es kann sich in Dickenrichtung des Mehrschichtkörpers eine Temperaturinhomogenität ausbilden, die bei einem Temperaturausdehnungskoeffizienten eines Materials einer Schicht, der von Null verschieden ist, innerhalb der Schicht und/oder des Mehrschichtkörpers zu einer mechanischen Spannung führen kann. Diese mechanische Spannung kann einen Riß oder einen Bruch der Schicht und/oder des Mehrschichtkörpers nachsichziehen. Die mechanische Spannung kann auch zu einer Verformung (Verwerfung) des Mehrschichtkörpers führen. Die Verformung ist bei einer Trägerschicht aus Glas im allgemeinen transient, d.h. nach dem Temperieren bildet sich die Verformung zurück. Die Verformung kann auch permanent sein. Dabei bildet sich die Verformung nicht zurück. Dies ist dann der Fall, wenn ein Erweichungspunkt der Trägerschicht (z.B. aus Glas) während des Temperierens überschritten wird und dabei eine (innere) mechanische Spannung und/oder eine äußere Kraft wirksam wird.

Je großflächiger der Mehrschichtkörper ist und je höher eine Temperierrate (Aufheizrate, Abkühlrate) ist, desto schwieriger ist es, während des Temperierens des Mehrschichtkörpers Temperaturinhomogenitäten im Mehrschichtkörper gezielt zu beeinflussen, und desto größer ist eine Wahrscheinlichkeit dafür, daß eine unerwünschte mechanische Spannung auftritt.

Aufgabe der Erfindung ist es, aufzuzeigen, wie während des Temperierens eines großflächigen Mehrschichtkörpers mit einer hohen Temperierrate eine Temperaturhomogenität bzw. Temperaturinhomogenität gezielt beeinflußt werden kann.

Zur Lösung der Aufgabe wird eine Vorrichtung zum Temperieren eines Mehrschichtkörpers nach Anspruch 1 angegeben. Die Idee der Erfindung besteht darin, die Schichten des Mehrschichtkörpers individuell aufzuheizen, d.h. die Teilmenge der Energiemenge, die eine Schicht aufnimmt, gezielt zu steuern, zu regulieren und/oder voreinzustellen. Beispielsweise wird eine Energiemenge mit Hilfe eines Regelkreises während des Temperierens bestimmt (siehe unten). Denkbar ist auch, daß eine Voreinstellung der Energiequellen (z.B. Energiedichte, Art der Energie, etc.) ohne einen zusätzlichen Regelkreis ausreicht. Durch die Erfindung ist ein individuelles Aufheizen der Schichten des Mehrschichtkörpers auch bei sehr hohen Aufheizraten von 1°C/s bis beispielsweise 50°C/s und mehr möglich. Durch das individuelle Aufheizen gelingt es, während des Temperierens eine mechanische Spannung und eine damit unter Umständen auftretende Verformung des Mehrschichtkörpers möglichst klein zu halten.

Basis dafür ist der Transparenzkörper, der optisch teildurchlässig (semitransparent) ist. Durch die Transmission, die beispielsweise bei einer bestimmten Wellenlänge zwischen 0,1 und 0,9 liegt, gelangt die oben beschriebene elektromagnetische Strahlung durch den Transparenzkörper auf eine Schicht. Die Schicht kann eine entsprechende Energiemenge bzw. Teilmenge der Energiemenge aufnehmen, die direkt von der Energiequelle ausgesendet wird.

Der Transparenzkörper weist aber auch eine gewisse Absorption für die elektromagnetische Strahlung auf. Die damit aufgenommenen Energie kann in Form von Wärmestrahlung und/oder Wärmeleitung an eine Umgebung abgegeben werden. In einer besonderen Ausgestaltung verfügt die Vorrichtung zum Temperieren eines Mehrschichtkörpers einen Transparenzkörper, der durch die Absorption der elektromagnetischen Strahlung eine Wärmestrahlung und/oder Wärmeleitung in Richtung des Mehrschichtkörpers aufweist. Somit gelingt es, eine Schicht durch Wärmestrahlung und/oder Wärmeleitung zu temperieren.

Denkbar ist auch, daß eine erste Schicht des Mehrschichtkörpers, die für die Wärmestrahlung eine Transmission zeigt, im wesentlichen nur durch Wärmeleitung temperiert wird, während eine zweite Schicht desselben Mehrschichtkörpers durch die Wärmestrahlung desselben Transparenzkörpers im wesentlichen temperiert wird. Eine erste Schicht mit einer entsprechenden Transmission ist beispielsweise eine Schicht aus Glas. Wenn eine elektromagnetische Strahlung einer Energiequelle und/oder eines Transparenzkörpers auf den Glaskörper trifft, wird ein geringer Anteil der Strahlung (etwa 4%) reflektiert. Der größte Anteil (>90%) gelangt mehr oder weniger ungehindert durch das Glas und trifft dann auf eine zweite Schicht des Mehrschichtkörpers. Dort kann diese Strahlung absorbiert werden und zu einer Aufnahme einer Energiemenge durch diese zweite Schicht führen. Die Glasschicht kann durch Strahlung bzw. Wärmestrahlung bei einer sehr hohen Aufheizrate nicht ausreichend schnell temperiert werden. Dagegen ist ein relativ schnelles Temperieren durch Wärmeleitung möglich, wenn der Transparenzkörper eine Teilmenge der Energiemenge aufnehmen und auf die Glasschicht übertragen kann.

Denkbar ist auch der Fall, daß der Transparenzkörper selbst eine Schicht des Mehrschichtkörpers ist. Der Transparenzkörper kann durch Absorption eines Teils der elektromagnetischen Strahlung eine Teilmenge der Energiemenge aufnehmen und durch die Transmission eine weitere Teilmenge der Energiemenge zur Aufnahme durch eine weitere Schicht durchlassen.

In einer besonderen Ausgestaltung wird bei dem Verfahren ein Mehrschichtkörper verwendet, bei dem eine Schicht als Trägerschicht für zumindest eine weitere Schicht fungiert. Der Mehrschichtkörper weist insbesondere eine unsymmetrische Schichtfolge auf. Beispielsweise besteht der Mehrschichtkörper aus einer einseitig beschichteten Trägerschicht. Einzelne Schichten des Mehrschichtkörpers können auch nebeneinander angeordnet sein.

In einer besonderen Ausgestaltung weist eine Schicht des Mehrschichtkörpers ein Material auf, das aus der Gruppe Glas, Glaskeramik, Keramik, Metall und/oder Kunststoff ausgewählt ist. Als Kunststoff kommt insbesondere temperaturbeständiger Kunststoff wie Teflon in Frage. Eine Schicht ist beispielsweise eine Metallfolie. Die Metallfolie kann auch als Trägerschicht fungieren.

Die Teilmenge der Energiemenge, die von einer Schicht aufgenommen wird, hängt beispielsweise von einer Absorptions-, Emissions- und/oder Reflexionseigenschaft der Schicht ab. Sie hängt aber auch von der Art der Energiequelle ab und von der Art und Weise, wie die Energiemenge auf den Mehrschichtkörper bzw. auf eine Schicht des Mehrschichtkörpers übertragen wird.

Das Temperieren des Mehrschichtkörpers bzw. einer Schicht erfolgt beispielsweise mit Hilfe einer Energiequelle für thermische Energie. Dabei kann der Schicht die thermische Energie direkt zugeführt werden. Hier kommt Wärmestrahlung, Wärmeleitung und/oder Konvektion in Frage. Im Fall der Wärmestrahlung kann die Energiequelle selbst eine Quelle für Wärmestrahlung sein. Die Wärmestrahlung ist beispielsweise elektromagnetische Strahlung im Wellenlängenbereich zwischen 0,7 und 4,5 µm (Infrarotlicht). Die entsprechende Schicht ist im Strahlungsfeld der Energiequelle angeordnet. Die Schicht wird von der elektromagnetischen Strahlung der Energiequelle getroffen und absorbiert zumindest teilweise die elektromagnetische Strahlung.

Möglich ist es aber auch, daß einer Schicht eine beliebige Energie zugeführt wird, die in der Schicht in thermische Energie umgewandelt wird. Beispielsweise wird eine Schicht mit hochenergetischem UV-Licht bestrahlt, das die Schicht absorbiert. Durch eine Absorption eines hochenergetischen Lichtquants gelangt ein Molekül der Schicht oder die ganze Schicht in einen elektronisch angeregten Zustand. Eine dabei aufgenommene Energie kann in thermische Energie umgewandelt werden.

Neben Wärmestrahlung und Wärmeleitung ist auch ein Temperieren einer Schicht bzw. des ganzen Körpers durch Konvektion möglich. Dabei wird ein Gas mit einer bestimmten Energie an der Schicht vorbeigeleitet, wobei das Gas die Energie an die Schicht abgibt. Vorbeigeleitetes Gas kann gleichzeitig als Prozeßgas fungieren.

Durch Wärmeleitung und/oder Konvektion kann im übrigen eine Schicht auch gekühlt werden. Dabei wird der Schicht eine negative thermische Energie zugeführt. Auf diese Weise ist es auch möglich, die Energiemengen bzw. die Teilmengen der Energiemengen zu steuern und z.B. die mechanischen Spannungen im Mehrschichtkörper zusätzlich zu beeinflussen.

In einer besonderen Ausgestaltung ist ein Energietransmitter zur Übertragung der Energiemenge auf den Mehrschichtkörper vorhanden. Der Energietransmitter fungiert als sekundäre Energiequelle. Der Energietransmitter absorbiert beispielsweise elektromagnetische Strahlung einer primären Energiequelle, z.B. einer Halogenlampe, aus einem höheren Energiebereich und konvertiert diese elektromagnetische Strahlung in Wärmestrahlung, die von der Schicht absorbiert wird.

Als Energietransmitter kann die mittelbare und/oder unmittelbare Umgebung des Mehrschichtkörpers während des Temperierens fungieren. Denkbar ist, daß ein Energietransmitter mit dem Mehrschichtkörper zum Temperieren in einem Innenraum eines Behälters angeordnet ist. Der Energietransmitter kann auch außerhalb des Behälters, beispielsweise auf einer Wandung des Behälters oder in einem Abstand zum Behälter angeordnet sein. Denkbar ist, daß der Energietransmitter eine Beschichtung des Behälters ist. Der Energietransmitter ist beispielsweise eine Graphitfolie. Der Behälter selbst kann auch selbst die Funktion eine Energietransmitters übernehmen. Eine derartige Funktion ist beispielsweise bei einem Behälter aus Graphit gegeben. Schließlich ist der Transparenzkörper nichts anderes als ein Energietransmitter. Ebenso fungiert ein Gas bei einer Energieübertragung durch Konvektion als Energietransmitter.

Eine Energiemenge, die der Mehrschichtkörper aufnimmt, kann nicht nur von Schicht zu Schicht, sondern auch innerhalb einer Schicht unterschiedlich sein. Beispielsweise tritt während des Temperierens ein Randeffekt im Mehrschichtkörper bzw. in einer Schicht eines Mehrschichtkörpers auf. Ein Randbereich der Schicht weist eine andere Temperatur auf als ein innerer Bereich der Schicht. Es stellt sich während des Temperierens ein lateraler Temperaturgradient ein. Dies geschieht beispielsweise dann, wenn ein Strahlungsfeld der Energiequelle inhomogen ist. Dabei ist eine Energiedichte des Stahlungsfeldes auf einer Fläche, die von der Strahlung durchstrahlt wird, nicht überall gleich. Ein laterale Temperaturinhomogenität kann sich auch bei einem homogenen Strahlungsfeld einstellen, wenn am Rand einer Schicht aufgrund der größeren absorbierenden Fläche pro Volumeneinheit eine größere Energiemenge pro Volumeneinheit absorbiert wird. Um den Temperaturgradienten auszugleichen, kann beispielsweise eine Energiequelle verwendet werden, die aus einer Vielzahl von Untereinheiten besteht. Jede Untereinheit kann separat angesteuert werden und so jede von einer Untereinheit auf eine Schicht zugeführte Energiemenge separat eingestellt werden. Eine derartige Energiequelle ist beispielsweise ein Array oder eine Matrix aus einzelnen Heizelementen. Ein Heizelement ist beispielsweise eine Halogenlampe. Das Array oder die Matrix kann auch dazu benutzt werden, einen lateralen Temperaturgradienten in der Schicht herzustellen. Dadurch könnte man beispielsweise eine permanente oder transiente Verformung des Schichtkörpers gezielt erzeugen. Insbesondere für die Temperierung eines Mehrschichtkörpers, bei dem Schichten nebeneinander liegen, ist ein Array oder eine Matrix von großem Vorteil

Bezüglich der Energiequelle ist es vorteilhaft, wenn die Energiequelle bzw. die Energiequellen in einem kontinuierlichen Betrieb arbeiten. Denkbar ist aber auch, daß die Energiequellen in einem Zyklus- und/oder Pulsbetrieb die Energiemenge bzw. die Teilmengen der Energiemenge den Schichten zur Verfügung stellen. Eine derartige Energiequelle ist beispielsweise eine Energiequelle mit gepulster elektromagnetischer Strahlung. Auf diese Weise kann den Schichten zur gleichen Zeit oder in einer zeitlichen Abfolge (z.B. alternierend) eine Energiemenge zugeführt werden.

Folgende Eigenschaften der Energiequelle für elektromagnetische Strahlung sind besonders vorteilhaft:
- Die Energiequelle weist ein homogenes Strahlungsfeld auf.
- Eine spektrale Intensitätsverteilung der Energiequelle überlappt teilweise mit einer spektralen Absorption der Schicht, des Transparenzkörpers und eines eventuell vorhandenen Behälters (siehe unten).
- In Gegenwart eines Prozeßgases ist die Energiequelle korrosionsfest und/oder korrosionsgeschützt.
- Die Energiequelle weist eine hohe Energiedichte auf, die ausreicht, um eine Masse des Mehrschichtkörpers (und eventuell die eines Behälters) mit einer Aufheizrate von über 1°C/s aufheizen zu können.

In einer besonderen Ausgestaltung weist der Transparenzkörper der Vorrichtung mindestens einen Abstandshalter auf, an den der Mehrschichtkörper zur Aufnahme einer lateral homogenen Energiemenge durch den Mehrschichtkörper angelegt werden kann. Beispielsweise wird der Schicht, über die der Mehrschichtkörper auf dem Transparenzkörper bzw. dem Abstandshalter aufliegt, in erster Linie durch eine homogene Wärmestrahlung temperiert. In dieser Form weist der Abstandshalter vorzugsweise ein Material auf, das eine geringe Absorption für die elektromagnetische Strahlung aufweist. Ein Abstandshalter überragt beispielsweise eine Oberfläche des Transparenzkörpers um einige µm bis mm.

Die auf den Abstandshaltern aufliegende Schicht kann auch in erster Linie durch Wärmeleitung temperiert werden. Dazu Verfügen die Abstandshalter beispielsweise über eine für eine entsprechende Temperierrate notwendige thermische Leitfähigkeit. Denkbar ist auch, daß der Abstandshalter für die Energieübertragung durch Wärmeleitung eine hohe Absorption für eine elektromagnetische Strahlung einer Energiequelle aufweist, wobei die elektromagnetische Strahlung effizient in thermische Energie umgewandelt wird.

Insbesondere weist der Transparenzkörper eine Vielzahl von derartigen Abstandshaltern auf. Bei einer Vielzahl von Abstandshaltern, die gleichmäßig zwischen der Schicht des Mehrschichtkörpers und dem Transparenzkörper berührend angeordnet sind, kann zusätzlich eine Homogenisierung der lateralen Temperaturverteilung erreicht werden.

In einer besonderen Ausgestaltung weist der Transparenzkörper und/oder der Abstandshalter ein Material auf, das aus der Gruppe Glas und/oder Glaskeramik ausgewählt ist. Glaskeramik weist verschiedene Vorteile auf:
- Es kann zum Temperieren in einem weiten Temperaturbereich von beispielsweise 0°C bis z.B. 700°C eingesetzt werden. Glaskeramik weist beispielsweise einen Erweichungspunkt auf, der über dem Temperaturbereich liegt.
- Es verfügt über einen sehr niedrigen thermischen Ausdehnungskoeffizienten. Es ist temperaturschockbeständig und im oben erwähnten Temperaturbereich des Temperierens verwerfungsfrei.
- Es ist gegenüber einer Vielzahl von Chemikalien chemisch inert und weist eine geringe Durchlässigkeit für diese Chemikalien auf. Eine derartige Chemikalie ist beispielsweise das Prozeßgas, dem eine Schicht und/oder der ganze Mehrschichtkörper während des Temperierens ausgesetzt ist.
- Es ist im Spektralbereich vieler Energiequellen für elektromagnetische Strahlung optisch teildurchlässig, insbesondere in einem Wellenlängenbereich, in dem eine Strahlungsdichte der Energiequellen hoch ist. Eine derartige Strahlungsquelle ist beispielsweise eine Halogenlampe mit einer hohen Strahlungsdichte zwischen 0,1 und 4,5 µm.

Glas, insbesondere Quarzglas sind als Material für den Transparenzkörper ebenfalls denkbar. Vorteilhaft daran ist eine hohe Einsatztemperatur von bis zu 1200°C. Diese Materialien zeigen im Spektralbereich einer Energiequelle in Form einer Halogenlampe eine hohe Transmission und eine geringe Absorption. Das Licht tritt im wesentlichen ungehindert durch diesen Transparenzkörper hindurch und gelangt an eine Schicht mit einer entsprechenden Absorption für die elektromagnetische Strahlung, wobei die Schicht eine Energiemenge aufnimmt und erwärmt wird. Der Transparenzkörper wird durch die Strahlung nahezu nicht erwärmt.

In einer Prozeßanwendung ist es möglich, daß Material der erwärmten Schicht verdampft und an einer relativ kalten Oberfläche des Transparenzkörper abgeschieden wird. Um dies zu verhindern, kann dafür gesorgt werden, daß der Transparenzkörper während des Temperierens auf eine nötige Temperatur erwärmt wird. Dies gelingt durch eine Übertragung einer Energiemenge auf den Transparenzkörper durch Wärmeleitung und/oder Konvektion. Denkbar ist auch eine elektromagnetische Strahlung, die der Transparenzkörper absorbiert. Denkbar ist, daß der Transparenzkörper eine Beschichtung aufweist, die einen bestimmten Teil der elektromagnetischen Strahlung absorbiert. Die dadurch aufgenommene Energie kann an den Transparenzkörper aus Glas oder Quarzglas weitergeleitet werden. In dieser Form ist der Transparenzkörper, bestehend aus dem Glaskörper mit der Beschichtung, optisch teildurchlässig und kann sowohl zur Energieübertragung durch Wärmestrahlung als auch durch Wärmeleitung auf den Mehrschichtkörper eingesetzt werden.

In einer besonderen Ausgestaltung der Erfindung kann mindestens eine Schicht mit einem Prozeßgas in Kontakt gebracht werden. Denkbar ist auch, daß der ganze Mehrschichtkörper dem Prozeßgas ausgesetzt ist. Das Prozeßgas wirkt während des Temperierens auf die Schicht bzw. auf einzelne Schichten oder den ganzen Mehrschichtkörper ein und ist an der Änderung der physikalischen und chemischen Eigenschaften des Mehrschichtkörpers beteiligt. Als Prozeßgas kommt beispielsweise ein Inertgas (molekularer Stickstoff oder Edelgas) in Frage. Das Prozeßgas reagiert nicht mit einem Material der Schicht. Denkbar ist aber auch ein Prozeßgas, das mit einem Material der Schicht reagiert. Unter Einwirken des Prozeßgases bildet sich die funktionelle Schicht. Beispielsweise wirkt das Prozeßgas gegenüber einem Material der Schicht oxidierend oder reduzierend. Mögliche Prozeßgase dafür sind Sauerstoff, Chlor, Wasserstoff, elementares Selen, Schwefel oder ein Hydrid. Es kann auch ein ätzendes Prozeßgase wie HCL oder ähnliches sein. Weitere Beispiele für das Prozeßgas sind H₂S und H₂Se, die bei der Herstellung einer Dünnfilmsolarzelle eingesetzt werden (siehe unten). Schließlich sind alle Gase oder auch Gasgemische denkbar, die in einer entsprechenden Weise mit einem Material einer Schicht reagieren.

Vorteilhaft ist es, wenn die Schicht einer definierten Prozeßgasatmosphäre ausgesetzt ist. Die definierte Prozeßgasatmosphäre umfaßt beispielsweise einen Partialdruck des oder der Prozeßgase während des Temperierens. Denkbar ist beispielsweise auch, daß eine Schicht oder der Mehrschichtkörper zum Temperieren mit Vakuum in Kontakt steht.

Eine definierte Prozeßgasatmosphäre läßt sich beispielsweise dadurch erreichen, daß das Prozeßgas mit einer bestimmten Geschwindigkeit an der Schicht vorbeigeleitet wird. Dabei kann ein Prozeßgas mit verschiedenen Partialdrücken im Verlauf des Temperierens auf die Schicht einwirken. Denkbar ist auch, daß nacheinander verschiedene Prozeßgase mit der Schicht des Schichtkörpers in Kontakt stehen.

Vorzugsweise ist zumindest die Schicht umschlossen, die mit dem Prozeßgas in Kontakt steht. Dies gelingt beispielsweise durch eine Umhüllung der Schicht, wobei die Umhüllung an der Trägerschicht befestigt sein kann. Die Umhüllung wird vor oder während des Temperierens mit dem Prozeßgas befüllt. Das Prozeßgas wird dabei auf einer Oberfläche der Schicht konzentriert, deren Eigenschaften durch das Prozeßgas beeinflußt werden soll. Auf diese Weise kann verhindert werden, daß eine Umgebung durch das Prozeßgas kontaminiert wird. Dies ist insbesondere bei einem korrosiven und/oder giftigen Prozeßgas wichtig. Außerdem kann mit einer für eine Umsetzung der Schicht nötigen stöchiometrischen Menge an Prozeßgas gearbeitet werden. Es wird Prozeßgas nicht unnötig verbraucht.

In einer besonderen Ausgestaltung der Erfindung ist ein Behälter zum Halten des Mehrschichtkörpers während des Temperierens vorhanden. Dabei ist insbesondere der Transparenzkörper eine Wandung des Behälters. Der Behälter hat den Vorteil, daß er automatisch die Umhüllung des Schicht bzw. den ganzen Mehrschichtkörpers darstellt. Die Umhüllung braucht nicht am Mehrschichtkörper befestigt sein. Bei einem verschließbaren Behälter kann die Prozeßgasatmosphäre gezielt und leicht eingestellt werden. Insbesondere weist der Behälter dazu mindestens eine Gasöffnung zum Evakuieren des Behälters und/oder Befüllen des Behälters mit dem Prozeßgas auf. In einer besonderen Ausführungsform ist die Gasöffnung durch ein selbstverschließbares Ventil realisiert. Die Prozeßgasatmosphäre kann aktiv eingestellt werden. Die Gasöffnung kann auch zum Befüllen des Behälters mit einem beliebigen Gas, beispielsweise einem Spülgas, verwendet werden. Die Prozeßgasatmosphäre kann auch während des Temperierens eingestellt oder nachgeregelt werden.

Zum gezielten Einstellen der Prozeßgasatmosphäre kann der Behälter aber auch ein genügen großes Volumen für das während des Temperierens benötigte Prozeßgas aufweisen. Wenn das Temperieren eine homogene und reproduzierbare Verteilung des Prozeßgases über einer Schicht erfordert, kann auch gezielt ein Gasaustritt aus dem Behälter eingestellt werden. Dies kann beispielsweise dann nötig sein, wenn mit einer sehr hohen Aufheizrate temperiert wird. Dabei expandiert das Prozeßgas. Wenn der Behälter dem dabei auftretenden Gasdruck nicht standhält, kommt es zu einer Verformung des Behälters oder sogar zur Zerstörung des Behälters. Eine Verformung sollte aber beispielsweise dann verhindert werden, wenn der Mehrschichtkörper auf dem Boden des Behälters aufliegt. Eine Verformung des Behälters führt wie oben beschrieben zu einer lateralen Temperaturinhomogenität im Mehrschichtkörper mit den entsprechenden Folgen.

Der Behälter kann zudem Transportmittel des Mehrschichtkörpers beim Temperieren sein. Der Behälter hat den Vorteil, daß während des Temperierens beispielsweise ein Bruch einer Schicht (Trägerschicht bzw. Substrat) aus Glas nicht ausgeschlossen werden kann. Bei einem Bruch eines solchen Substrats kann das zerbrochene Material leicht aus einer Anlage zum Temperieren des Mehrschichtkörpers entfernt werden. Dies trägt zu einer Prozeßstabilisierung der Anlage zum Temperieren bei.

In einer besonderen Ausgestaltung ist die Wandung des Behälters, die den Transparenzkörper aufweist, ein Deckel und/oder ein Boden des Behälters. Beipielsweise liegt der Mehrschichtkörper mit eine Schicht direkt auf dem Transparenzkörper des Bodens auf. Der Transparenzkörper kann, wie oben beschrieben, Abstandshalter aufweisen. Der Deckel weist ebenfalls den Transparenzkörper auf, der beispielsweise nicht mit dem Mehrschichtkörper bzw. einer Schicht des Mehrschichtkörpers in Kontakt steht. Auf diese Weise kann die Schicht des Mehrschichtkörpers, die auf dem Boden aufliegt durch Wärmeleitung, die dem Deckel zugewandte Schicht durch Wärmestrahlung aufgeheizt werden. Die dem Deckel zugewandte Schicht kann leicht einem Prozeßgas ausgesetzt sein.

Der Deckel des Behälters kann aber auch durch hohe Absorbtion der elektromagnetischen Strahlung, die von einer Energiequelle ausgesendet wird, gekennzeichnet sein. In einer weiteren Ausgestaltung ist der Boden und/oder der Deckel des Behälters von jeweils mindestens einem Mehrschichtkörper gebildet. Dabei ist die Schicht des Mehrschichtkörpers, die z.B. mit einem Prozeßgas in Berührung kommen sollen, in einen Innenraum des Behälters gerichtet. Diese Lösung ist möglich, wenn der Mehrschichtkörper bzw. die Schichten des Mehrschichtkörpers einen niedrigen Temperaturausdehnungskoeffizienten aufweisen und/oder die Temperierrate gering ist. Für eine hohe Temperierrate verfügt der Mehrschichtkörper vorteilhaft über eine Trägerschicht mit einem hohen thermischen Leitfähigkeitskoeffizienten. Die Trägerschicht ist nach außen gerichtet. Beispielsweise ist hier die Trägerschicht ein oben beschriebener Transparenzkörper.

Mit dem Behälter eignet sich die Vorrichtung insbesondere zum Durchführen des Temperierens in einem Durchlaufverfahren mit verschiedenen Verfahrensstufen, die in unterschiedlichen Prozeßzonen durchgeführt werden (Inline-Verfahren).

Der Transport des Behälters kann im Durchlaufverfahren entweder kontinuierlich oder diskontinuierlich erfolgen. Beim kontinuierlichen Durchlaufverfahren wird das Prozessiergut oder der Prozessierbehälter während des gesamten Durchlaufes durch die Prozessieranlage bewegt. Der diskontinuierliche oder auch sogenannte "Indexbetrieb" des Durchlaufverfahrens ist dadurch gekennzeichnet, daß die Prozessierbox oder das Prozessiergut nur während des Transfers von einer Prozeßzone in die andere bewegt wird und dann in der Verfahrensstufe so lange verweilt, bis der Teilprozeß abgeschlossen ist. Dabei ist es von Vorteil, daß die Transferzeit möglichst kurz gegenüber der Verweilzeit ist. Anschließend erfolgt ein Weitertransportieren in die nächste Prozeßzone und wieder einen Verweilen usw. Für Durchlaufanlagen, die für den Indexbetrieb ausgelegt sind, ist es vorteilhaft, daß jede Prozeßzone die Größe mindestens eines Prozessierbehältnisses hat, damit die Homogenität einer Prozesszone (wie z.B. Temperatur) auf das Prozessiergut übertragen werden kann. In einer weiteren Ausgestaltung haben alle Prozessierzonen, die im Indexbetrieb beschickt werden, in Transportrichtung die gleichen Abmessungen. Somit können mit einfachen Transportmechanismen wie Transportkette, Transportband oder Pusher-Transport nicht nur eine Prozeßzone, sondern auch alle benachbarten Prozeßzonen im Indexbetrieb simultan be-und entladen werden.

Der Mehrschichtkörper wird beispielsweise in den Behälter gelegt. Mit dem Behälter wird der Mehrschichtkörper von Verfahrensstufe zu Verfahrensstufe bzw. von Prozeßzone zu Prozeßzone transportiert. Jede Verfahrensstufe, beispielsweise ein Heizen, Kühlen, Evakuieren oder Befüllen des Behälters, kann in einer eigenen Prozeßzone durchgeführt werden. In einer ersten Verfahrensstufe wird der Behälter beispielsweise mit einem Prozeßgas befüllt. Dabei kann der Behälter in einer eigens dafür vorhandenen Kammer eingebracht und dort evakuiert, mit einem entsprechenden Prozeßgas befüllt und verschlossen werden. Denkbar ist dabei ein separater Ein- und Auslaß (Gasöffnung) des Behälters zum Spülen oder Befüllen des Behälters mit dem Prozeßgas. Diese Gasöffnung kann mit einer Ankoppeleinheit und Positioniereinheit zur Gasbefüllung oder zum Evakuieren der Prozessierbox verbunden werden. Die Ankoppeleinheit dient beispielsweise dazu, den Behälter in einem Durchlaufverfahren beispielsweise im Indexbetrieb zur Durchführung einer Verfahrensstufe an einem bestimmten Ort (Prozeßzone) mit einer entsprechenden Einheit (z.B. Vakuumpumpe, Gasflasche) derart zu verbinden, daß der Behälter mit dem entsprechenden Gas befüllt oder entleert werden kann.

In einer besonderen Ausgestaltung weist der Behälter eine Ankoppeleinheit auf zum Anordnen des Behälters in einer Prozeßzone. Mit Hilfe der Ankoppeleinheit ist es möglich, den Behälter in einer Prozeßzone zu halten bzw. positionieren. Dazu verfügt beispielsweise die Prozeßzone ebenfalls über eine Ankoppeleinheit. Die Ankoppeleinheit dient beispielsweise dazu, den Behälter in einem Durchlaufverfahren zur Durchführung einer Verfahrensstufe an einem bestimmten Ort (Prozeßzone) zu halten und mit einer entsprechenden Einheit (z.B. Vakuumpumpe, Gasflasche) derart zu verbinden, daß der Behälter mit dem entsprechenden Gas befüllt oder der Behälter entleert werden kann. Die Ankoppeleinheit des Behälters und die Ankoppeleinheit der Prozeßzone funktionieren beispielsweise nach dem Schlüssel-Loch-Prinzip.

Denkbar ist auch ein Transport des Behälters von Prozeßzone zu Prozeßzone mit Hilfe der Ankoppeleinheit.

Folgender Verfahrensablauf ist denkbar: In einer ersten Verfahrensstufe wird der Behälter beispielsweise mit einem Prozeßgas befüllt. Dabei kann der Behälter in einer eigens dafür vorhandenen Kammer eingebracht und dort evakuiert, mit einem entsprechenden Prozeßgas befüllt und verschlossen werden. Denkbar ist dabei ein separater Ein- und Auslaß (Gasöffnung) des Behälters zum Spülen oder Befüllen des Behälters mit dem Prozeßgas. Insbesondere weist die Gasöffnung des Behälters eine Ankoppeleinheit zum Ankoppeln des Behälters an eine Ankoppeleinheit einer Prozeßzone auf.

Diese Gasöffnung kann dabei als Ankoppeleinheit und/oder Positioniereinheit dienen. In einer zweiten Verfahrensstufe findet das Temperieren statt. Dazu wird der Behälter aus der Kammer in eine Heizzone transportiert. Nach Beendigung des Temperierens wird der Mehrschichtkörper aus den Heizzonen in die Kühlzonen zum Durchführen einer weiteren Verfahrensstufe befördert.

Das Transportieren im Durchlauf- oder sogenannten Inline-Verfahren erfolgt beispielsweise dadurch, daß eine Vielzahl von Behältern mit Mehrschichtkörpern in Form eines Zuges durch die Inline-Anlage geführt werden. Durch Anstoßen eines Behälters wird der ganze Zug in Gang gesetzt. Die Behälter werden simultan bewegt. Diese Art des Transportierens wird als "Pusher-Antrieb" bezeichnet. Vorteilhaft erfolgt hier das Transportieren im "Index-Betrieb".

In einer besonderen Ausgestaltung ist die Vorrichtung in einer Prozessierkammer angeordnet ist, die ausgewählt ist aus der Gruppe Vakkuumkammer, Atmosphärenkammer und/oder Hochdruckkammer. Innerhalb der Prozessierkammer kann eine gesamte Inline-Anlage integriert sein. Beispielsweise ist eine Heiz- oder Kühlzone durch eine Schleuse für den Behälter mit dem Mehrschichtkörper zugänglich oder gegenüber einer weiteren Prozeßzone in der Prozessierkammer separiert. Denkbar ist insbesondere, dass mehrere Prozessierkammern vorhanden sind, z.B. eine Heizzone mit einwandiger Prozessierkammer, Kühlzone mit doppelwandiger Kammer, die wassergekühlt ist. Mit dem Behälter findet ein Transport von Prozessierkammer zu Prozessierkammer statt.

In einer besonderen Ausgestaltung weist der Transparenzkörper und/oder der Energietransmitter und/oder der Behälter und/oder die Prozessierkammer ein Material auf, das gegenüber einem Prozeßgas inert ist. Vorteilhaft ist überdies, daß eine gesamte Prozeßumgebung des Temperierens inert gegenüber dem verwendeten Prozeßgas ist. Zur Prozeßumgebung zählt beispielsweise auch die Energiequelle (primäre Energiequelle).

Das Material wird in Abhängigkeit vom Prozeßgas gewählt. Denkbar ist beispielsweise Glas, Glaskeramik und Keramik. Ein faserverstärktes Material wie kohlefaserverstärkter Graphit kann ebenso verwendet werden. Denkbar ist auch ein Material wie SiC, das einen hohen thermischen Leitfähigkeitskoeffizienten aufweist. Der Behälter und/oder die Prozessierkammer können ganz oder teilweise aus einem Metall oder einer Legierung bestehen. Ebenso ist ein bis zu einer bestimmten Temperatur beständigen Kunststoff möglich.

Neben einer chemischen Inertheit gegenüber dem Prozeßgas sind folgende Eigenschaften für das Material des Behälters von Vorteil:
- Das Material des Behälters ist unter den Bedingungen des Temperierens verwerfungsfrei. Es ist außerdem temperaturschockbeständig. Dies ist insbesondere dann der Fall, wenn es einen geringen Temperaturausdehnungskoeffizienten aufweist.
- Der thermische Erweichungspunkt des Materials des Behälters liegt über einer maximalen Temperatur des Temperierens.
- Der Behälter zeigt eine geringe bzw. definierte Permeabilität gegenüber einem Prozeßgas.

In einer besonderen Ausgestaltung ist eine Einrichtung zur Detektion eines Ausmaßes zumindest eines vom Temperieren abhängigen physikalischen Parameters der Vorrichtung zur Regelung der ersten und zweiten Teilmenge der Energiemenge vorhanden.

Ein denkbarer Parameter ist eine Absorptions-, Transmissions- und/oder Reflexionseigenschaft einer Schicht. Das Ausmaß des Parameters ist der Wert des Parameters. Beispielsweise kann eine Wellenlänge eines Absorptionsmaximums von der Temperatur abhängen. Das Ausmaß des Parameters wäre in diesem Fall die entsprechende Wellenlänge.

Insbesondere ist der Parameter eine Temperatur des Mehrschichtkörpers. Dabei ist das Ausmaß ein Wert der Temperatur. Denkbar ist auch die Detektion der Temperatur einer Schicht des Mehrschichtkörpers, des Transparenzkörpers und/oder des Behälters bzw. einer Wandung des Behälters. Es kann während des Temperierens ständig zumindest ein Parameter des Mehrschichtkörpers und/oder einer Schicht detektiert werden. Beispielsweise wird aufgrund der detektierten Temperatur einer Schicht die Teilmenge der Energiemenge erhöht oder erniedrigt, die von der Schicht aufgenommen wird. Dadurch kann eine Temperaturinhomogenität bzw. ein Temperaturgradient in Dikkenrichtung des Mehrschichtkörpers vermieden werden. Diese Temperaturinhomogenität kann aber auch, falls dies nötig sein sollte, erhöht werden. Beispielsweise ist die Einrichtung zur Detektion der Temperatur ein Pyrometer sein, der auf die Schicht gerichtet ist. Das Pyrometer detektiert beispielsweise die Wärmestrahlung, die von der Schicht ausgesendet wird. Aufgrund der Wärmestrahlung kann auf die Temperatur der Schicht rückgeschlossen werden. Denkbar ist auch ein Temperaturdetektor, der mit der Schicht verbunden ist und durch Wärmeleitung temperiert wird.

Vorstellbar ist auch, daß die Temperatur der Schicht oder des Mehrschichtkörpers nicht unmittelbar gemessen, sondern mittelbar gemessen wird. Beispielsweise wird ein Pyrometer auf den Behälter gerichtet, in dem der Mehrschichtkörper temperiert wird. Die Temperatur des Behälters kann durch die Temperatur des Mehrschichtkörpers beeinflußt sein. Aufgrund der Temperatur des Behälters wird auf die Temperatur der Schicht des Mehrschichtkörpers rückgeschlossen. Es wird die Energiemenge bzw. die Teilmenge der Energiemenge aufgrund der gemessenen Temperatur des Behälters geregelt. Dazu ist beispielsweise vor dem Temperieren eine Art "Eichmessung" durchzuführen, die einen Zusammenhang zwischen gemessener Temperatur der Behälters und tatsächlicher Temperatur der Schicht bzw. des Schichtkörpers wiedergibt. Die "Eichmessung" gibt einen Soll-Wert der Temperatur an. Der Ist-Wert wird detektiert. Ein Vergleich zwischen Soll-Wert und Ist-Wert liefert eine Regelungsgröße zur Regelung der Energiemengen.

Die Detektion (und auch die Regelung der Teilmengen der Energiemenge) erfolgt insbesondere mit einer örtlichen Auflösung in Dickenrichtung des Mehrschichtkörpers und mit einer zeitlichen Auflösung im zeitlichen Rahmen des Temperierens. Beispielsweise wird der Mehrschichtkörper mit einer Temperierrate von 25°C/s aufgeheizt. Dann würden sowohl die Detektion als auch die Regelung der Teilmengen der Energiemenge so schnell stattfinden, daß ein Temperaturunterschied zwischen den Schichten des Mehrschichtkörpers während des Temperierens beispielsweise unter einen vorgeschriebenen Maximum bleibt.

Die Temperaturinhomogenität in Dickenrichtung kann in Verbindung mit einer transienten Verformung des Mehrschichtkörpers auch zu einer lateralen Temperaturinhomogenität im Mehrschichtkörper führen. Lateral bedeutet beispielsweise innerhalb einer Schicht des Mehrschichtkörpers senkrecht zur Dikkenrichtung. Wie eingangs beschrieben, liegt der Mehrschichtkörper während des Temperierens beispielsweise auf einem Boden aus Graphit auf. Die Zufuhr bzw. die Aufnahme der Energiemenge durch die auf dem Boden aufliegenden Schicht des Mehrschichtkörpers erfolgt durch Wärmeleitung. Durch eine Temperaturinhomogenität in Dickenrichtung kann eine transiente Verformung des Mehrschichtkörpers in Form einer Verbiegung des Mehrschichtkörpers auftreten. Dabei wird der für die Wärmeleitung notwendige Kontakt zwischen dem Mehrschichtkörper und dem Boden des Behälters teilweise gelöst. Infolge davon kommt es zu einer lateralen Temperaturinhomogenität der aufliegenden Schicht bzw. des Mehrschichtkörpers. Besonders vorteilhaft ist es daher, wenn zur Detektion des Parameters (und Regelung der Energiemengen) nicht nur in Dickenrichtung, sondern auch lateral eine örtliche Auflösung vorliegt.

In einer besonderen Ausgestaltung ist der Parameter eine Verformung des Mehrschichtkörpers. Aufgrund einer auftretenden Temperaturinhomogenität kann es zu einer Verformung kommen. Beispielsweise wird der Mehrschichtkörper konkav gekrümmt. Der Mehrschichtkörper liegt auf dem Boden beispielsweise eines Behälters auf. Durch eine konkave Verformung entsteht im Randbereich des Mehrschichtkörpers ein Abstand zwischen der Auflagefläche und dem Mehrschichtkörper. Ein Ausmaß einer derartigen Verformung kann beispielsweise mit einer Einrichtung zur Laserinterferometrie oder Laserlichtreflexion detektiert werden. Aufgrund des Ausmaßes findet die Regelung der Energiemengen statt. Vorteilhaft ist es, wenn das Ausmaß in einem frühen Stadium der Verformung erkannt wird und schnell darauf regiert werden kann.

Für eine angesprochene Einrichtung zur Detektion eines Ausmaßes eines vom Temperieren abhängigen Parameters mit Hilfe einer optischen Einrichtung (z.B. Laser) ist es vorteilhaft, wenn die zu untersuchende Schicht für Licht der optischen Einrichtung zugänglich ist und ein Detektionssignal eindeutig dem zu detektierenden Parameter zuzuordnen ist. Die Wellenlänge eines Lasers sollte sich beispielsweise hinreichend von der Wärmestrahlung des Mehrschichtkörpers unterscheiden. Wenn die Vorrichtung mit einem Behälter ausgestattet ist, wäre es vorteilhaft, wenn der Transparenzkörper für das Licht des Lasers genügend durchlässig ist.

Mit Hilfe der Vorrichtung ist es auch möglich, eine gewünschte Verformung des Mehrschichtkörpers zu erzielen. Dazu kann es auch sinnvoll sein, die Verformung während des Temperierens wie oben beschrieben zu verfolgen. Es kann zum Beispiel eine gekrümmte Dünnfilmsolarzelle hergestellt werden. Zur gezielten Verformung wird beispielsweise der Mehrschichtkörper auf eine entsprechende Form bzw. Maske gelegt. Die Form bzw. Maske kann direkt eine Energiequelle sein. Der Mehrschichtkörper wird über einen Erweichungspunkt der Trägerschicht erwärmt. Als Folge davon nimmt der Mehrschichtkörper eine entsprechende Form der Maske bzw. der Form an. Die Maske ist beispielsweise in einem Boden des Behälters integriert. Die Maske könnte z.B. der Transparenzkörper sein.

Gemäß einem zweiten Aspekt der Erfindung wird ein Verfahren zum Temperieren eines Mehrschichtkörpers angegeben, der eine erste und mindestens eine zweite Schicht aufweist, durch Aufnahme einer Energiemenge durch den Mehrschichtkörper mit einer Aufnahme einer ersten Teilmenge der Energiemenge durch die erste Schicht und einer Aufnahme einer zweiten Teilmenge der Energiemenge durch die zweite Schicht, wobei zumindest eine Energiequelle zum Zuführen der Energiemenge auf den Mehrschichtkörper verwendet wird. Dabei wird insbesondere eine zuvor beschriebene Vorrichtung verwendet. Die Verfahrensschritte sind: Anordnen des Mehrschichtkörpers zwischen einer ersten und mindestens einer zweiten Energiequelle, so daß die erste Schicht zwischen der ersten Energiequelle und der zweiten Schicht und die zweite Schicht zwischen der zweiten Energiequelle und der ersten Schicht angeordnet ist, wobei als Energiequelle zumindest eine Energiequelle für eine bestimmte elektromagnetische Strahlung mit einem Strahlungsfeld verwendet wird, und zumindest eine der Schichten die elektromagnetische Strahlung absorbiert und im Strahlungsfeld der Energiequelle angeordnet wird, und Anordnen eines Transparenzkörpers im Strahlungsfeld der Energiequelle zwischen der Energiequelle und der Schicht, die im Strahlungsfeld der Energiequelle liegt und die die bestimmte elektromagnetische Strahlung absorbiert und Temperieren des Mehrschichtkörpers.

In einer besonderen Ausgestaltung absorbiert der Transparenzkörper eine bestimmte Energiemenge und führt die Energiemenge der Schicht zu. Insbesondere erfolgt dies durch Wärmeleitung und/oder Wärmestrahlung vom Transparenzkörper auf die Schicht.

In einer besonderen Ausgestaltung wird mindestens eine Schicht mit einem Prozeßgas in Kontakt gebracht. Dies geschieht vor, während und/oder nach dem Temperieren. Es kann dabei nicht nur eine Schicht, sondern der ganze Mehrschichtkörper mit dem Prozeßgas in Kontakt gebracht werden.

In einer weiteren Ausgestaltung wird während des Temperierens ein Detektieren eines vom Temperieren abhängigen Ausmaßes eines physikalischen Parameters des Mehrschichtkörpers zur Regelung der Aufnahme der Energiemenge während des Temperierens und Regelung der ersten und zweiten Teilmengen der Energiemenge durchgeführt. In einer besonderen Ausgestaltung führt der Transparenzkörper die Schicht die Energiemenge durch Wärmeleitung und/oder Wärmestrahlung zu.

In einer besonderen Ausgestaltung wird das Verfahren als Verfahrensstufe in einem Durchlaufverfahren und/oder Quasidurchlaufverfahren mit mindestens zwei Verfahrensstufen durchgeführt. Jede der Verfahrensstufen wird an einem separaten Ort (Prozeßzone) durchgeführt. Insbesondere wird dabei die oben beschriebene Vorrichtung mit dem Behälter verwendet, um den Mehrschichtkörper von Prozeßzone zu Prozeßzone zu transportieren. Die Verfahrensstufen können z.B. Heizzonen oder Kühlzonen sein, die mit Ankoppeleinheiten zur Gasbefüllung oder Entleerung der Behältnisse ausgestattet sein können. Die Verfahrensstufen können durch eine umgebende Prozessierkammer miteinander verbunden sein. Die umgebende Hülle kann z.B. eine Vakuumkammer, eine Atmosphärendruckkammer oder eine Hochdruckkammer sein. Weiterhin können die Verfahrensstufen am Einlaß und Auslaß mit Vakuum- oder Hochdruckschleusen für das Prozessiergut versehen sein.

Gemäß einem weiteren Aspekt der Erfindung wird ein Mehrschichtkörper angegeben, aufweisend eine erste Schicht aus mindestens einem aus der Gruppe Kupfer, Indium, Gallium, Schwefel, und/oder Selen ausgewählten Stoff und einer zweiten Schicht aus Glas, wobei ein lateraler Durchmesser des Mehrschichtkörpers aus dem Bereich zwischen 0,3 m und 5 m ausgewählt ist. Vorzugsweise beträgt der Durchmesser über 1,0 m bis 5m.

In einer besonderen Ausgestaltung wird der Mehrschichtkörper durch das oben beschriebene Verfahren hergestellt. Dabei wird mindestens ein Stoff der ersten Schicht des Mehrschichtkörpers aus der Gruppe Kupfer, Indium, Gallium, Schwefel und Selen ausgewählt und eine zweiten Schicht aus Glas verwendet. Der lateraler Durchmesser (Abmessung) des Mehrschichtkörpers wird aus dem Bereich zwischen 0,3 m und 5 m ausgewählt. Die Schicht ist beispielsweise ein Kupfer-Indium-Selenid-Halbleiterschicht. Der angegebene Mehrschichtkörper ist beispielsweise ein Dünnfilmsolarzelle bzw. ein Dünnfilmsolarmodul, das aus einer Vielzahl von seriell verschalteten einzelnen Dünnfilmsolarzellen besteht. Das Glas ist vorzugsweise Sodalime-Glas. Die entsprechende Schicht fungiert als Trägerschicht. Auf der Trägerschicht ist eine Molybdänschicht als Elektrode und über der Molybdänschicht eine funktionelle Schicht, nämlich eine Kupfer-Indium-Gallium-Sulfo-Selenid(CIGSSe)-Halbleiterschicht, aufgetragen. Eine Dicke des Schichtkörpers, bestehend aus Glaskörper und Halbleiterschicht beträgt typischerweise 2 bis 4 mm, mit einer Molybdänschicht von ca. 0,5 µm und einer Halbleiterschicht von ca. 3 µm. Der angegebene Bereich für die Dicke des Mehrschichtkörpers ist nicht ausschließend zu verwenden. Begrenzender Faktor ist eine Fähigkeit, ein großes Substrat herzustellen, das möglichst plan ist und damit mit der beschriebenen Vorrichtung bzw. mit dem beschriebenen Verfahren zu einem Mehrschichtkörper verarbeitet werden kann.

Zusammengefaßt ergeben sich mit der Erfindung folgende Vorteile:
- Es kann ein großflächiger Mehrschichtkörper mit einem unsymmetrischen Schichtaufbau (z.B. Mehrschichtkörper mit einer einzigen Schicht auf einer Trägerschicht) mit einer hohen Temperierrate von über 1 °C/s temperiert.
- Die Schichten des Mehrschichtkörpers können dabei einen stark unterschiedlichen thermischen Leitfähigkeitskoeffizienten aufweisen.
- Durch eine zeitliche und örtliche Auflösung der Detektion und der Regelung eines Ausmaßes eines vom Temperieren abhängigen Parameters gelingt ein Temperieren besonders sicher.
- Das Temperieren bis nahe eines Erweichungspunkts einer Trägerschicht ist möglich.
- Beim Temperieren über den Erweichungspunkt der Trägerschicht ist eine permanente Verformung des Mehrschichtkörpers möglich.
- Durch die Verwendung eines Behälters kann eine definierte Temperierungsumgebung mit einer definierten Prozeßgasatmosphäre geschaffen werden. Insbesondere kann ein toxisches und/oder korrosives Prozeßgas eingesetzt werden.
- Das Verfahren kann in einer Durchlaufanlage mit einem hohen Durchsatz durchgeführt werden.

Anhand eines Ausführungsbeispiels und der dazugehörigen Figuren wird eine Vorrichtung zum Temperieren eines Mehrschichtkörpers und ein entsprechendes Verfahren dazu vorgestellt. Die Figuren sind schematisch und stellen keine maßstabsgetreuen Abbildungen dar.
- Figur 1: zeigt einen Querschnitt einer Vorrichtung zum Temperieren eines Mehrschichtkörpers von der Seite.
- Figur 2: zeigt einen Querschnitt einer Vorrichtung zum Temperieren mit einem Behälter, in dem der Mehrschichtkörper angeordnet ist.
- Figur 3: zeigt einen Querschnitt einer Vorrichtung zum Temperieren mit einem Behälter, in dem der Mehrschichtkörper und ein Energietransmitter angeordnet sind.
- Figur 4: zeigt ein Ausschnitt eines Transparenzkörpers.

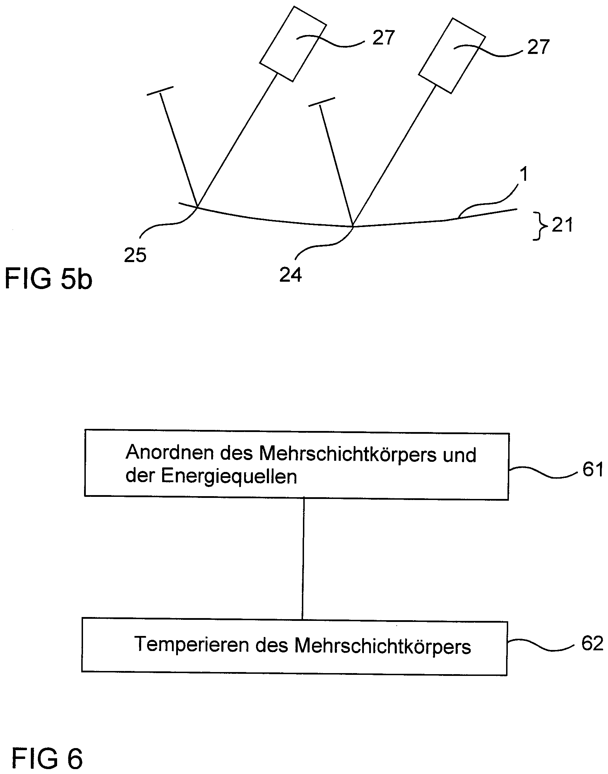

- Figuren 5a und 5b: zeigen eine Einrichtung zur Detektion des Ausmaßes einer Verformung des Mehrschichtkörpers.
- Figur 6: zeigt ein Ablaufdiagramm eines Verfahrens zum Temperieren eines Mehrschichtkörpers.
- Figur 7: zeigt eine Vorrichtung zum Temperieren eines Mehrschichtkörpers, die in einer Prozessierkammer angeordnet ist.
- Figuren 8a und 8b: zeigen jeweils ein Durchlaufverfahren.
- Figuren 9a und 9b: zeigen einen Behälter mit Ankoppeleinheit im Prozessiermodus und im Transportmodus

In den Ausführungsbeispielen wird ein Dünnfilmsolarmodul 1 hergestellt. Das Dünnfilmsolarmodul weist eine Grundfläche von 850 x 600 mm² auf. Die Dicke des Solarmoduls beträgt 3 mm, wobei auf einer Trägerschicht aus Sodalime-Glas 2 eine 0,5 µm dicke Schicht aus Molybdän 3 und eine 0,5 µm dicke Kupfer-Indium-Gallium-Sulfo-Selenid(CIGSSe)-Halbleiterschicht 4 hergestellt wird.

Vor dem Temperieren weist der Mehrschichtkörper 1 folgenden Schichtaufbau auf: Sodalime-Glas/Molybdän/Kupfer(Gallium)/Indium/Selen. Sodalime-Glas fungiert als Trägerschicht 2 der Molybdänschicht 3 und der mehrlagigen Schicht 4. In die Kupferschicht ist Gallium eingelagert. Als Prozeßgas 16 wird ein Gasgemisch aus Schwefelwasserstoff, Helium und Wasserstoff verwendet. Gasförmiges Selen bzw. Selenwasserstoff wird im Verlauf des Temperierens gebildet.

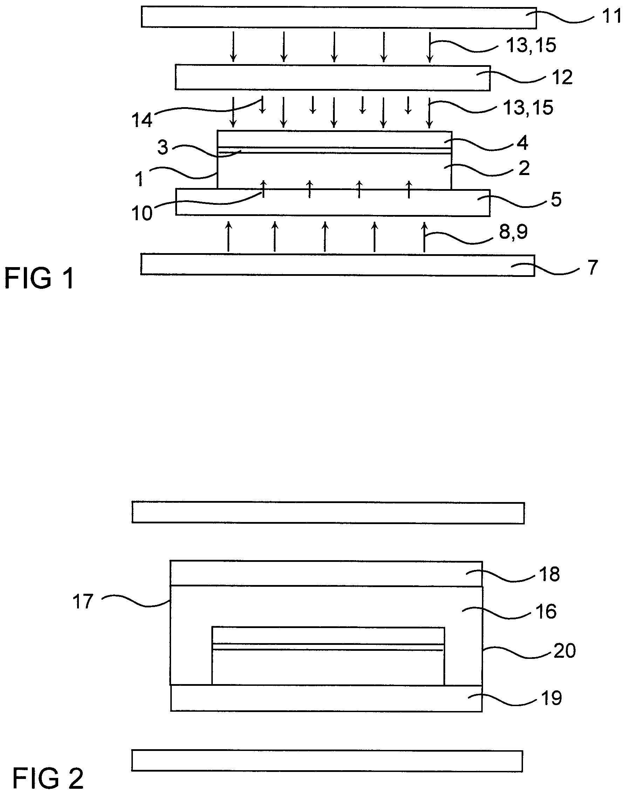

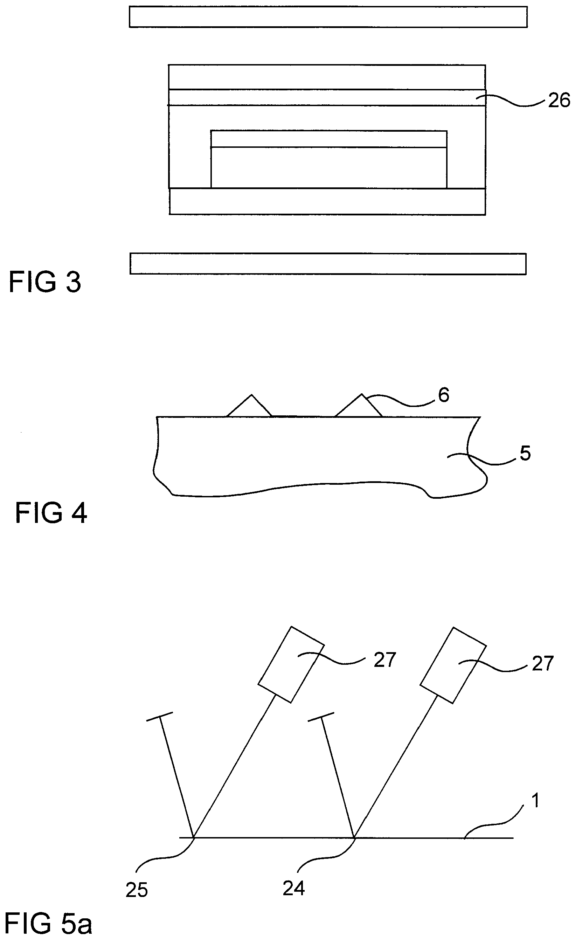

Gemäß einer ersten Ausführungsform wird der Mehrschichtkörper auf einen Transparenzkörper 5 aus Glaskeramik gelegt (Figur 1). Der Transparenzkörper weist eine Vielzahl von Abstandshaltern 6 aus dem gleichen Material auf, aus dem der Transparenzkörper 5 besteht (Figur 4). Der Transparenzkörper 5 befindet sich zwischen der Trägerschicht 2 der Dünnfilmsolarmodul bzw. dessen Ausgangsform 1 und eine Energiequelle 7. Die Energiequelle 7 besteht aus mehreren nebeneinander zu einer Matrix angeordneten Arrays aus Halogenlampen. Die Matrix liefert ein homogenes Strahlungsfeld 8. Der Transparenzkörper 5 befindet sich im Strahlungsfeld 8 der Energiequelle 7. Er absorbiert einen Teil der elektromagnetischen Strahlung 9 der Energiequelle und gibt die absorbierte Energiemenge durch Wärmeleitung 10 an die Trägerschicht 2 weiter. Die Glasschicht 2 wird in erster Linie durch die Wärmeleitung 10 temperiert.

Zwischen einer zweiten Energiequelle 11 und der Selenschicht (äußerste Beschichtung der Schicht 4) ist eine zweiter Transparenzkörper 12 aus Glaskeramik angeordnet. Die zweite Energiequelle 11 ist genauso wie die erste Energiequelle 11 als Matrix gestaltet. Der zweite Transparenzkörper 12 absorbiert einen Teil der elektromagnetischen Strahlung 13 der zweiten Energiequelle 11. Ein Teil der dabei aufgenommenen Energiemenge wird in Form von Wärmestrahlung 14 an die mehrlagige Schicht 4 abgegeben. Der Transparenzkörper 12 zeigt auch eine Transmission für die elektromagnetische Strahlung 13, so daß diese Strahlung auf die mehrlagige Schicht 4 auftrifft. Die mehrlagige Schicht 4 liegt im Strahlungsfeld 15 der Energiequelle 13. Die mehrlagige Schicht 4 wird in erster Linie durch Wärmestrahlung 14 temperiert.

Der Mehrschichtkörper 1 wird in einem Behälter 17 in oben beschriebener Weise angeordnet (Figur 2). Der Deckel 18 und der Boden 19 werden von den Transparenzkörpern 5 und 12 gebildet. Eine seitliche Wandung 20 des Behälters 17 besteht aus Kohlenfaserverstärktem Kohlenstoff (CFC).

Nach dem Ablegen des Mehrschichtkörpers auf der Bodenplatte wird der Behälter mit dem Prozeßgas befüllt und verschlossen. Danach erfolgt das Temperieren mit einer Temperierrate von 5°C/s, wobei die Energiequelle 7 und 11 getrennt geregelt werden.

Ein weiteres Ausführungsbeispiel zeichnet sich dadurch aus, daß ein Energietransmitter 26 in der Box integriert ist (Figur 3).

Für die Energiequelle 7 kommt folgender Regelkreis zum Einsatz: Ein laterales Ist-Temperaturprofil des Transparenzkörpers 5 wird mit einem Pyrometer in Form eines Infrarotsensor geeigneter Wellenlänge gemessen. Durch die Auflage des Mehrschichtkörpers kann mittels einer Kalibrierung aus dem Temperaturprofil des Transparenzkörpers das Temperaturprofil der Trägerschicht 2 bestimmt werden. Durch einen Regelalgorithmus über Ist- und Soll-Wert der Temperatur des Transparenzkörpers wird ein Regelsignal bestimmt, mit dem die Strahlungsleistung der Energiequelle 7 geregelt wird.

Eine Regelgröße für einen Regelkreis zur Steuerung des Energiequelle 11 ist eine transiente Verbiegung 21 der Trägerschicht 2. Die Verbiegung 21 wird durch Laserinterferometrie an der Substratseite 22 oder Schichtseite 23 gemessen. Meßpunkte sind die Substratmitte 24 und eine Ecke 25 des Mehrschichtkörpers. Bei der Laserinterferometrie wird die durch eine Verbiegung hervorgerufene Abstandsänderung gemessen und daraus das Regelsignal für die zugehörige Energiequelle ermittelt.

In einem weiteren Ausführungsbeispiel ist die Regelgröße für die Energiequelle 11 die Temperatur des Transparenzkörpers 12.

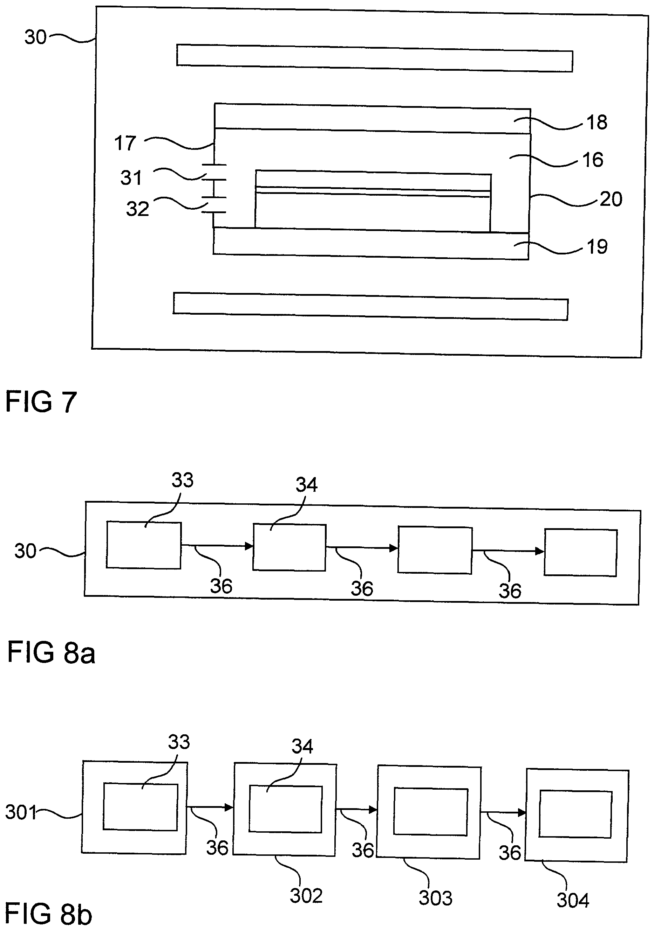

Ein weiteres Ausführungsbeispiel ist in Figur 7 angedeutet. Der Behälter 17 verfügt über Gasöffnungen in Form eines Gaseinlasses 31 und einen Gasauslasses 32. Diese Öffnungen verfügen beispielsweise über ein verschließbares Ventil, das nach beendetem Gasaustausch geschlossen wird. Während eines Transports des Behälters 17 mit dem Mehrschichtkörper 1 zur nächsten Prozeßzone ist das Ventil geschlossen. Eine der Prozeßzonen ist eine Heizzone. Die Heizzone besteht aus zwei Arrays aus Halogenlampen. Mit dem Transport des Behälters (mit Transparenzkörper) in die Heizzone zwischen die beiden Arrays wird die Vorrichtung zum Temperieren erzeugt.

Ein weiteres Ausführungsbeispiel ist ebenfalls in Figur 7 angedeutet. Dabei befindet sich die gesamte Vorrichtung in einer Prozessierkammer 30, die evakuiert und mit einem bestimmten Gas befüllt werden kann.

In den Figuren 8a und 8b ist das Prinzip eines Durchlaufverfahrens mit Hilfe einer Inline-Anlage angedeutet. In einer ersten Ausführung ist die gesamte Inline-Anlage in der Prozessierkammer 30 angeordnet (Figur 8a). Es findet ein Transport 36 des Mehrschichtkörpers 1 im Behälter 17 von Prozeßzone 33 zu Prozeßzone 34 statt. An jeder der Prozeßzonen wird eine unterschiedliche Verfahrensstufe durchgeführt. In der Prozeßzone 33 wird der Behälter 17 mit dem Prozeßgas befüllt und beheizt. In der Prozeßzone 34 wird der Behälter 17 evakuiert und abgekühlt. Alternativ dazu ist jeder der Prozeßzonen 33 und 34 in einer eigenen, separierten Prozeßkammer 301 bis 304 angeordnet (Figur 8b). Die Inline-Anlage ist über mehrere Prozeßkammern verteilt. Die Prozeßkammern sind mit Schleusen versehen, durch die die Behälter in die Prozeßkammern gelangen.

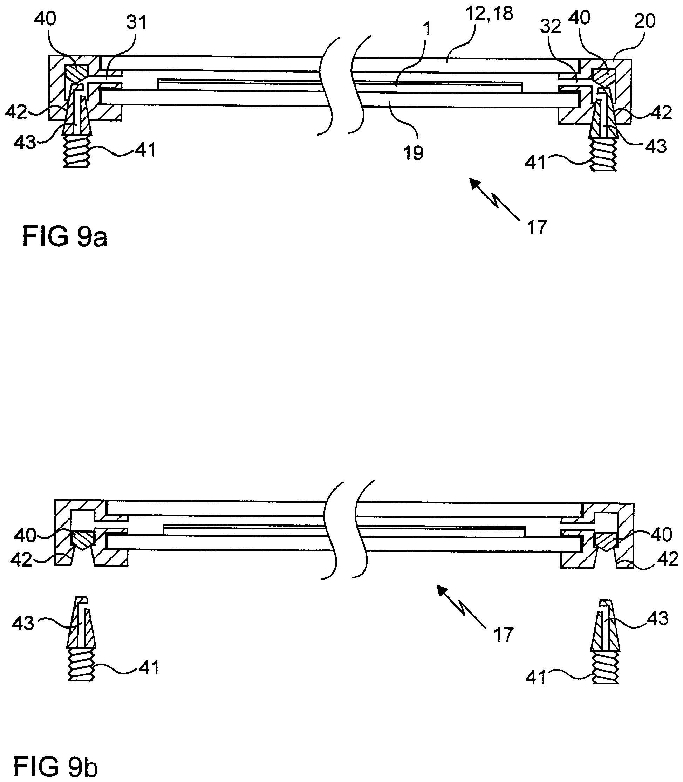

In den Figuren 9a und 9b ist aufgezeigt, wie eine Anordnung zum Temperieren bzw. Prozessieren einschließlich Ankoppeleinheit ausgeführt sein kann. Figur 9a zeigt einen Querschnitt des Behälters 17 im Prozessiermodus. Der Behälter 17 weist einen Deckel 18 in Form eines Transparenzkörpers 12 auf. Der Boden 19 besteht aus einem hoch absorbierenden Material. Das Material ist in einer Ausführungsform Graphit. Eine seitliche Wandung 20 des Behälters 17 ist ein Rahmen des Behälters 17 aus CFC. In der seitlichen Wandung des Behälters sind Gaseinlass 31 und Gasauslass 32 integriert. Ebenfalls integriert in die seitliche Wandung 20 sind selbstschließende Ventile 40. Mit diesen Ventilen können die Gasöffnungen 31 und 32 zum Evakuieren des Behälters oder Befüllen des Behälters mit einem Gas geöffnet bzw. verschlossen werden.

Ebenfalls integriert in die seitliche Wandung ist eine Ankoppeleinheit 42 des Behälters der Prozeßzone 33. Die Ankoppeleinheit 42 kann beispielsweise als konusförmige Öffnung ausgeführt sein. Mit dieser Öffnung wird der Behälter 17 auf eine invers zu Öffnung geformten Ankoppeleinheit 41 der Prozeßzonen gesteckt. In den Ankoppeleinheiten 41 und 42 sind Gasleitungen 43 integriert. Wenn der Behälter auf diese Weise mit beispielsweise der Prozeßzone 33 angeordnet ist, kann beispielsweise während dieser Verfahrensstufe ein beliebiges Prozeßgas ein- oder ausgeleitet werden oder das Prozessierbehältnis evakuiert und mit Inertgas gespült werden. In der dargestellten Form dient die Ankoppeleinheiten 42 des Behälters 17 und der Prozeßzone 33 der Herstellung einer Prozeßgasatmosphäre.

Nach beendetem Prozessieren bzw. Temperieren erfolgt das Abziehen der Ankoppeleinheit und das selbsttätige Schließen der Ventile 40. Anschließend kann im Transportmodus der Transport des Behälters zur nächsten Prozeßzone 34 erfolgen. Die zone 34 kann beispielsweise mit einer weiteren Ankoppeleinheit versehen sein, die beispielsweise aufgebrauchtes Prozessiergas nachlädt oder ein neues Prozessiergas einführt.

## Patentansprüche

1. Vorrichtung zum Temperieren eines Mehrschichtkörpers (1), der eine erste Schicht (2,3, 4) und mindestens eine zweite Schicht (2,3, 4) aufweist, durch Aufnahme einer Energiemenge durch den Mehrschichtkörper (1) mit einer Aufnahme einer ersten Teilmenge der Energiemenge durch die erste Schicht (2, 3, 4) und einer Aufnahme einer zweiten Teilmenge der Energiemenge durch die zweite Schicht (2, 3, 4), aufweisend
- mindestens eine Energiequelle (7, 11) der Energiemenge, wobei
- eine erste und mindestens eine zweite Energiequelle vorhanden sind,
- mindestens eine der Energiequellen (7, 11) eine Emission einer bestimmten elektromagnetischen Strahlung (13) mit einem Strahlungsfeld (9, 15) aufweist,
- mindestens eine der Schichten (2, 4) eine bestimmte Absorption für die elektromagnetische Strahlung (8, 13) aufweist,
- die erste Schicht (2) zwischen der ersten Energiequelle (7) und der zweiten Schicht (4) und die zweite Schicht (4) zwischen der zweiten Energiequelle (11) und der ersten Schicht (2) derart angeordnet werden kann, dass sich die Schicht (2, 4) mit der Absorption für die elektromagnetische Strahlung (8, 13) im Strahlungsfeld (9, 15) befindet, und
- im Strahlungsfeld (9, 15) zwischen der Energiequelle (7, 11) mit dem Strahlungsfeld (9, 15) und der Schicht (2, 4), die die Absorption für die elektromagnetische Strahlung (8, 13) aufweist, mindestens ein für die elektromagnetische Strahlung (8, 13) optisch teildurchlässiger Transparenzkörper (5, 12) angeordnet ist, wobei der Transparenzkörper (5, 12) ein Material aus Glaskeramik aufweist, wobei der Transparenzkörper (5, 12) eine Wandung (18, 19, 20) eines Behälters (17) zum Halten des Mehrschichtkörpers (1) während des Temperierens ist, wobei die Wandung ein Deckel (18) und ein Boden (19) des Behälters (17) ist, wobei der Mehrschichtkörper (1) mit einer Schicht direkt auf dem Transparenzkörper des Bodens (19) aufliegt.

2. Vorrichtung nach Anspruch 1, wobei mindestens ein Energietransmitter (26) zur Übertragung der Energiemenge auf den Mehrschichtkörper (1) vorhanden ist, wobei der Energietransmitter (26) elektromagnetische Strahlung absorbiert und in eine Wärmestrahlung, die von der Schicht (2, 4) absorbiert wird, konvertiert.

3. Vorrichtung nach Anspruch 1 oder 2, wobei der Transparenzkörper (5, 12) eine Vielzahl von Abstandshaltern (6) aufweist, an denen der Mehrschichtkörper (1) angelegt werden kann, wobei zur Homogenisierung der lateralen Temperaturverteilung des Mehrschichtkörpers (1) die Abstandshalter (6) gleichmäßig zwischen der Schicht des Mehrschichtkörpers und dem Transparenzkörper berührend angeordnet sind.

4. Vorrichtung nach Anspruch 3, wobei die Abstandshalter (6) ein Material aufweisen, das aus der Gruppe Glas und/oder Glaskeramik ausgewählt ist.

5. Vorrichtung nach Anspruch 1, wobei der Behälter (17) mindestens eine Gasöffnung (31, 32) zum Evakuieren des Behälters und/oder Befüllen des Behälters mit einem Prozessgas aufweist.

6. Vorrichtung nach Anspruch 5, wobei die Gasöffnung (31, 32) des Behälters (17) eine Ankoppeleinheit (42) zum Ankoppeln des Behälters (17) an eine Ankoppeleinheit (41) einer Prozesszone (33, 34) aufweist, wobei der Behälter (17) mittels der Ankoppeleinheit (42) in der Prozesszone (33, 34) gehalten oder von Prozesszone (33, 34) zu Prozesszone (33, 34) bewegt werden kann.

7. Vorrichtung nach Anspruch 6, wobei der Behälter (17) in einem Durchlaufverfahren zur Durchführung einer Verfahrensstufe mittels der Ankoppeleinheit (42) in der Prozesszone (33, 34) gehalten und mit einer Einheit derart verbunden ist, dass der Behälter (17) mit Gas befüllt oder entleert werden kann.

8. Vorrichtung nach einem der Ansprüche 1 bis 7, wobei die Vorrichtung in einer Prozessierkammer (30, 301, 302, 303, 304) angeordnet ist, die ausgewählt ist aus der Gruppe Vakuumkammer, Atmosphärenkammer und/oder Hochdruckkammer.

9. Vorrichtung nach einem der Ansprüche 1 bis 8, wobei der Transparenzkörper (5, 12) und/oder der Energietransmitter (26) und/oder der Behälter (17) und/oder die Prozessierkammer ein Material aufweisen, das gegenüber dem Prozessgas (16) inert ist.

10. Vorrichtung nach einem der Ansprüche 1 bis 9, wobei mindestens eine Einrichtung (27) zur Detektion eines Ausmaßes (21) zumindest eines vom Temperieren abhängigen physikalischen Parameters der Vorrichtung zur Regelung der ersten und zweiten Teilmenge der Energiemenge vorhanden ist.

11. Vorrichtung nach Anspruch 10, wobei der Parameter eine Verformung des Mehrschichtkörpers darstellt.

12. Verfahren zum Temperieren eines Mehrschichtkörpers, der eine erste und mindestens eine zweite Schicht aufweist, durch Aufnahme einer Energiemenge durch den Mehrschichtkörper mit einer Aufnahme einer ersten Teilmenge der Energiemenge durch die erste Schicht und einer Aufnahme einer zweiten Teilmenge der Energiemenge durch die zweite Schicht, wobei zumindest eine Energiequelle zum Zuführen der Energiemenge auf den Mehrschichtkörper verwendet wird, unter Verwendung einer Vorrichtung nach einem der Ansprüche 1 bis 11, mit den Verfahrensschritten:
a) Anordnen des Mehrschichtkörpers zwischen einer ersten und mindestens einer zweiten Energiequelle,
- so dass die erste Schicht zwischen der ersten Energiequelle und der zweiten Schicht und die zweite Schicht zwischen der zweiten Energiequelle und der ersten Schicht angeordnet ist,
- wobei als Energiequelle zumindest eine Energiequelle für eine bestimmte elektromagnetische Strahlung mit einem Strahlungsfeld verwendet wird,
- und zumindest eine der Schichten die elektromagnetische Strahlung absorbiert und im Strahlungsfeld der Energiequelle angeordnet wird,
und Anordnen eines Transparenzkörpers aus Glaskeramik im Strahlungsfeld der Energiequelle zwischen der Energiequelle und der Schicht, die im Strahlungsfeld der Energiequelle liegt und die die bestimmte elektromagnetische Strahlung absorbiert, wobei der Transparenzkörper (5, 12) eine Wandung (18, 19, 20) eines Behälters (17) zum Halten des Mehrschichtkörpers (1) während des Temperierens ist, wobei die Wandung ein Deckel (18) und ein Boden (19) des Behälters (17) ist, wobei der Mehrschichtkörper (1) mit einer Schicht direkt auf dem Transparenzkörper des Bodens (19) aufliegt,
b) Temperieren des Mehrschichtkörpers, wobei zum Temperieren der Transparenzkörper eine bestimmte Energiemenge absorbiert und die Energiemenge der dem Boden aufliegenden Schicht durch Wärmeleitung und Wärmestrahlung zuführt.

13. Verfahren nach Anspruch 12, wobei zumindest ein Material einer der Schichten des Mehrschichtkörpers aus der Gruppe Glas, Glaskeramik, Keramik, Kunststoff und/oder Metall ausgewählt wird.

14. Verfahren nach einem der Ansprüche 12 oder 13, wobei während des Temperierens ein Detektieren eines vom Temperieren abhängigen Ausmaßes eines physikalischen Parameters der Vorrichtung zur Regelung der Aufnahme der Energiemenge während des Temperierens und eine Regelung der Energiemenge durchgeführt wird.

15. Verfahren nach einem der Ansprüche 12 bis 14, wobei mindestens eine Schicht (2, 3, 4) mit einem Prozessgas (16) in Kontakt gebracht wird.

16. Verfahren nach einem der Ansprüche 12 bis 15, wobei das Verfahren als Verfahrensstufe (33, 34) in einem Durchlaufverfahren und/oder Quasidurchlaufverfahren mit mindestens zwei Verfahrensstufen durchgeführt wird.

17. Verfahren nach einem der Ansprüche 12 bis 16, wobei ein Mehrschichtkörper hergestellt wird mit einer ersten Schicht aus mindestens einem Stoff, der aus der Gruppe Kupfer, Indium, Gallium, Schwefel und/oder Selen ausgewählt wird, und einer zweiten Schicht aus Glas, wobei eine Abmessung des Mehrschichtkörpers aus dem Bereich zwischen 0,3 m und 5 m ausgewählt wird.

## Claims

1. Device for tempering of a multi-layer body (1) which comprises a first layer (2,3, 4) and at least one second layer (2,3, 4) by taking up a quantity of energy through the multi-layer body (1) comprising taking-up of a first portion of the quantity of energy by the first layer (2, 3, 4) and taking-up of a second portion of the quantity of energy by the second layer (2, 3, 4), comprising
- at least one energy source (7, 11) of the quantity of energy,
wherein
- a first and at least one second energy source are present,
- at least one of the energy sources (7, 11) has an emission of a specific electromagnetic radiation (13) having a radiation field (9, 15),
- at least one of the layers (2, 4) has a specific absorption for the electromagnetic radiation (8,13),
- the first layer (2) can be arranged between the first energy source (7) and the second layer (4) and the second layer (4) can be arranged between the second energy source (11) and the first layer (2) in such a manner that the layer (2, 4) having the absorption for the electromagnetic radiation (8, 13) is situated in the radiation field (9, 15), and
- at least one transparency body (5, 12) which is optically partially transmissive for the electromagnetic radiation (8, 13) is arranged in the radiation field (9, 15) between the energy source (7,11) having the radiation field (9, 15) and the layer (2, 4) having the absorption for the electromagnetic radiation (8, 13), wherein the transparency body (5, 12) has a material made of glass ceramic, wherein the transparency body (5, 12) is a wall (18, 19, 20) of a container (17) for supporting the multi-layer body (1) during the tempering, wherein the wall is a cover (18) and a bottom (19) of the container (17), wherein the multi-layer body (1) lies with a layer directly on the transparency body of the bottom (19).

2. Device according to claim 1, comprising at least one energy transmitter (26) for transmitting the quantity of energy to the multi-layer body (1), wherein the energy transmitter absorbs electromagnetic radiation and converts it into heat radiation, which is absorbed by the layer (2, 4).

3. Device according to claim 1 or 2, wherein the transparency body (5, 12) has a plurality of spacers on which the multi-layer body (1) can be applied, wherein, in order to homogenize the lateral temperature distribution of the multi-layer body (1), the spacers (6) are arranged uniformly between the layer of the multi-layer body and the transparency body in a contacting manner.

4. Device according to claim 3, wherein the spacers (6) have a material which is selected from the group of glass and/or glass ceramic.

5. Device according to claim 1, wherein the container (17) has at least one gas opening (31, 32) for evacuating the container and/or filling the container with a process gas.

6. Device according to claim 5, wherein the gas opening (31, 32) of the container (17) comprises a coupling unit (42) for coupling the container (17) to a coupling unit (41) of a process zone (33, 34), wherein the container (17) is held by means of the coupling unit (42) in the process zone (33, 34) or can be moved from process zone (33, 34) to process zone (33, 34).

7. Device according to claim 6, wherein the container (17) is held by means of the coupling unit (42) in the process zone in a continuous process for carrying out a process stage and is connected to a unit in such a manner that the container (17) can be filled with gas or emptied.

8. Device according to one of claims 1 to 7, wherein the device is arranged in a process chamber (30, 301, 302, 303, 304) which is selected from the group of a vacuum chamber, atmospheric chamber and/or high-pressure chamber.

9. Device according to one of claims 1 to 8, wherein the transparency body (5, 12) and/or the energy transmitter (26) and/or the container (17) and/or the processing chamber have a material which is inert with respect to the process gas (16).

10. Device according to one of claims 1 to 9, wherein at least one installation (27) for detecting an amount (21) of at least one physical parameter of the device which is dependent on the tempering for controlling the first and second portions of the quantity of energy.

11. Device according to claim 10, wherein the parameter represents a deformation of the multi-layer body.

12. Method for tempering a multi-layer body which has a first and at least one second layer by taking up a quantity of energy through the multi-layer body comprising taking-up of a first portion of the quantity of energy by the first layer and taking-up of a second portion of the quantity of energy by the second layer, wherein at least one energy source for supplying the quantity of energy to the multi-layer body is used, comprising the following method steps:
a) arranging the multi-layer body between a first and at least one second energy source,
- so that the first layer is arranged between the first energy source and the second layer and the second layer is arranged between the second energy source and the first layer,
- wherein at least one energy source for a specific electromagnetic radiation having a radiation field is used as the energy source,
- and at least one of the layers absorbs the electromagnetic radiation and is arranged in the radiation field of the energy source,
and arranging a transparency body made of glass ceramic in the radiation field of the energy source between the energy source and the layer, which is in the radiation field of the energy source and absorbs the specific electromagnetic radiation, wherein the transparency body (5, 12) is a wall (18, 19, 20) of a container (17) for holding the multi-layer body (1) during the tempering, wherein the wall is a cover (18) and a bottom (19) of the container (17), wherein the multi-layer body (1) lies with a layer directly on the transparency body of the bottom (19),
b) tempering of the multi-layer body, wherein, for tempering, a certain amount of energy is absorbed by the transparency body which supplies the quantity of energy to the layer resting on the floor by means of heat conduction and thermal radiation.

13. Method according to claim 12, wherein at least one material of one of the layers of the multi-layer body is selected from the group of glass, glass ceramic, ceramic, plastic and/or metal.

14. Method according to one of claims 12 or 13, wherein during the tempering, a detection of an amount of a physical parameter of the device is carried out in order to control the uptake of the quantity of energy during the tempering and a regulation of the energy quantity is carried out.

15. Method according to one of claims 12 to 14, wherein at least one layer is brought into contact with a process gas (16).

16. Method according to one of claims 12 to 15, wherein the method is carried out as a process stage (33, 34) in a continuous process and/or quasi-continuous process with at least two process stages.

17. Method according to one of claims 12 to 16, wherein a multi-layer body is produced having a first layer made of at least one substance selected from the group consisting of copper, indium, gallium, sulfur and/or selenium, and a second layer of glass, wherein a dimension of the multi-layer body is selected from the range between 0.3 m and 5 m.

## Revendications

1. Dispositif pour tempérer un corps multicouche (1), qui présente une première couche (2, 3, 4) et au moins une deuxième couche (2, 3, 4), par l'absorption d'une quantité d'énergie à travers le corps multicouche (1) avec une absorption d'une première portion de la quantité d'énergie par le biais de la première couche (2, 3, 4) et une absorption d'une deuxième portion de la quantité d'énergie par le biais de la deuxième couche (2, 3, 4), présentant
- au moins une source d'énergie (7, 11) de la quantité d'énergie,
où
- une première et au moins une deuxième source d'énergie sont disponibles,
- au moins l'une des sources d'énergie (7, 11) présente une absorption d'un rayonnement électromagnétique spécifique (13) avec un champ de rayonnement (9, 15),
- au moins l'une des couches (2, 4) présente une absorption spécifique des rayonnements électromagnétiques (8, 13),
- la première couche (2) entre la première source d'énergie (7) et la deuxième couche (4) et la deuxième couche (4) entre la deuxième source d'énergie (11) et la première couche (2) peuvent être disposées de telle manière que la couche (2, 4) avec l'absorption des rayonnements électromagnétiques (8, 13) se situe dans le champ de rayonnement (9, 15), et
- au moins un corps de transparence optiquement semi-transparent (5, 12) au rayonnement électromagnétique (8, 13) est agencé dans le champ de rayonnement (9, 15) entre la source d'énergie (7, 11) avec le champ de rayonnement (9, 15) et la couche (2, 4), qui présente l'absorption des rayonnements électromagnétiques (8, 13), où le corps de transparence (5, 12), présente un matériau en vitrocéramique, où le corps de transparence (5, 12) forme le contour (18, 19, 20) d'un réservoir (17) pour maintenir le corps multicouche (1) lors de la trempe, où le contour est un couvercle (18) et un fond (19) du réservoir (17), où le corps multicouche (1) repose avec une couche directement sur le corps de transparence du fond (19).

2. Dispositif selon la revendication 1, où au moins un transmetteur d'énergie (26) pour la transmission de la quantité d'énergie sur le corps multicouche (1) est fourni, où le transmetteur d'énergie (26) absorbe le rayonnement électromagnétique et le transforme en rayonnement thermique qui est absorbé par la couche (2, 4).

3. Dispositif selon la revendication 1 ou 2, où le corps de transparence (5, 12) présente une variété d'écarteurs (6), contre lesquels le corps multicouche (1) peut être appliqué, où les écarteurs (6) sont répartis de manière uniforme entre la couche du corps multicouche et touchant le corps de transparence pour l'homogénéisation de la distribution de la température latérale du corps multicouche (1).

4. Dispositif selon la revendication 3, où les entretoises (6) présente un matériel sélectionné parmi le groupe constitué de verre et/ou vitrocéramique.

5. Dispositif selon la revendication 1, où le réservoir (17) possède au moins une ouverture de gaz (31, 32) pour l'évacuation du réservoir et/ou le remplissage du réservoir d'un gaz de processus.

6. Dispositif selon la revendication 5, où l'ouverture de gaz (31, 32) du réservoir (17) possède une unité de couplage (42) pour coupler le réservoir (17) sur une unité de couplage (41) d'une zone de processus (33, 34), où le réservoir (17) est maintenu dans la zone de processus (33, 34) au moyen de l'unité de couplage (42) ou peut être déplacé de zone de processus (33, 34) en zone de processus (33, 34).

7. Dispositif selon la revendication 6, où le réservoir (17) est maintenu par le biais d'une unité de couplage (42) dans la zone de processus (33, 34) dans un processus continu pour la réalisation d'une étape de processus et est associé à une unité, de manière à pouvoir remplir le réservoir (17) de gaz ou l'évacuer.

8. Dispositif selon l'une des revendications 1 à 7, où le dispositif est disposé dans une chambre de traitement (30, 301, 302, 303, 304) sélectionnée parmi le groupe constitué de chambre à vide, chambre à atmosphère et/ou chambre à haute pression.

9. Dispositif selon l'une des revendications 1 à 8, où le corps de transparence (5, 12) et/ou le transmetteur d'énergie (26), et/ou le réservoir (17) et/ou la chambre de traitement présente un matériau, qui est inerte par rapport au gaz de processus (16).

10. Dispositif selon l'une des revendications 1 à 9, où au moins une installation (27) est fournie pour la détection d'une quantité (21), d'au moins un paramètre physique dépendant de la trempe du dispositif pour le réglage de la première et de la deuxième portion de la quantité d'énergie.

11. Dispositif selon la revendication 10, où le paramètre représente une déformation du corps multicouche.

12. Procédure pour tempérer un corps multicouche, qui présente une première et au moins une deuxième couche, par l'absorption d'une quantité d'énergie à travers le corps multicouche avec une absorption d'une première portion de la quantité d'énergie par le biais de la première couche et une absorption d'une deuxième portion de la quantité d'énergie par le biais de la deuxième couche, où au moins une source d'énergie est utilisée pour fournir la quantité d'énergie au corps multicouche, en utilisant un dispositif selon l'une des revendications 1 à 11 comprenant les étapes suivantes :
a) disposition du corps multicouche entre une première et au moins une deuxième source d'énergie,
- ainsi la première couche est disposée entre la première source d'énergie et la deuxième couche et la deuxième couche entre la deuxième source d'énergie et la première couche
- où au moins une source d'énergie est utilisée comme source d'énergie pour un rayonnement électromagnétique spécifique avec un champ de rayonnement,
- et au moins une des couches absorbe le rayonnement électromagnétique et est disposé dans le champ de rayonnement
et disposition d'un corps de transparence en vitrocéramique dans le champ de rayonnement de la source d'énergie entre la source d'énergie et la couche qui se trouve dans le champ de rayonnement de la source d'énergie et absorbe le rayonnement électromagnétique spécifique, où le corps de transparence (5, 12) forme un contour (18, 19, 20) d'un réservoir (17) pour maintenir le corps multicouche (1) lors de la trempe, où le contour est un couvercle (18) et un fond (19) du réservoir (17), où le corps multicouche (1) repose avec une couche directement sur le corps de transparence du fond (19).
b) trempe du corps multicouche, où le corps de transparence absorbe une certaine quantité d'énergie pour la trempe et dirige la quantité d'énergie jusqu'à la couche reposant sur le fond par la conduction et la radiation de chaleur.

13. Procédé selon la revendication 12, où au moins un matériau de l'une des couches du corps multicouche est sélectionné parmi le groupe constitué de verre, vitrocéramique, céramique, plastique et/ou métal.

14. Procédé selon l'une des revendications 12 ou 13, où une détection d'une mesure dépendant de la trempe d'un paramètre physique du dispositif pour le réglage de l'absorption de la quantité d'énergie au cours de la trempe et un réglage de la quantité d'énergie sont effectués au cours de la trempe.

15. Procédé selon l'une des revendications 12 à 14, où au moins une couche (2, 3, 4) est mise en contact avec un gaz de procédé (16).

16. Procédé selon l'une des revendications 12 à 15, où la procédure est effectuée en tant qu'étape de procédure (33, 34) dans une procédure continue ou une procédure presque continue avec au moins deux étapes de procédure.

17. Procédé selon l'une des revendications 12 à 16, où un corps multicouche est fabriqué avec une première couche en au moins un matériau choisi parmi le groupe constitué de cuivre, indium, gallium, soufre et/ou sélénium et une deuxième couche en verre, où une dimension du corps multicouche est sélectionnée dans une zone située entre 0,3 m et 5 m.
